(19) Europäisches Patentamt
European Patent Office
Office européen des brevets

(11) **EP 4 211 749 B1**

(12) **EUROPEAN PATENT SPECIFICATION**

(45) Date of publication and mention
of the grant of the patent:
**22.01.2025 Bulletin 2025/04**

(21) Application number: **20786519.7**

(22) Date of filing: **05.10.2020**

(51) International Patent Classification (IPC):
*H01Q 1/24* (2006.01)       *H01Q 1/52* (2006.01)
*H01Q 5/378* (2015.01)      *H01Q 7/00* (2006.01)

(52) Cooperative Patent Classification (CPC):
**H01Q 1/246; H01Q 1/521; H01Q 1/523;
H01Q 5/378; H01Q 7/00**

(86) International application number:
**PCT/EP2020/077793**

(87) International publication number:
**WO 2022/073577 (14.04.2022 Gazette 2022/15)**

(54) **ANTENNA DEVICE WITH RADIATING LOOP**

**ANTENNENVORRICHTUNG MIT STRAHLUNGSSCHLEIFE**

**DISPOSITIF D'ANTENNE À BOUCLE RAYONNANTE**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**19.07.2023 Bulletin 2023/29**

(73) Proprietor: **Huawei Technologies Co., Ltd.
Shenzhen, Guangdong 518129 (CN)**

(72) Inventors:
• **BISCONTINI, Bruno
80992 Munich (DE)**
• **SEMILOVSKY, Dmitrij
80992 Munich (DE)**
• **GONZALEZ, Ignacio
80992 Munich (DE)**

(74) Representative: **Epping - Hermann - Fischer
Patentanwaltsgesellschaft mbH
Schloßschmidstraße 5
80639 München (DE)**

(56) References cited:
EP-A1- 1 751 821        WO-A1-2022/022804
US-A1- 2017 346 191     US-A1- 2018 261 929
US-A1- 2019 319 352     US-A1- 2020 243 970

## Description

TECHNICAL FIELD

The present disclosure relates generally to the field of telecommunication devices, and more specifically, to an antenna device with a radiating loop.

BACKGROUND

With the development of new wireless communication technologies, such as fifth generation (5G) or upcoming 6G communication technology, there is a growing demand to develop antenna devices for reliable communication. One of the key technologies to enable the new generation of mobile communications is massive Multiple-Input and Multiple-Output (m MIMO), for example, below 6 gigahertz (GHz). Typically, new deployments of antenna devices in telecom infrastructure continue to face many challenges including local regulations. For example, there are limitations associated with a size of a given antenna that can be deployed. In order to facilitate certain activities related to telecommunication services, such as site acquisition and/or reuse of current mechanical support structures at the sites, it is expected that the form factor and the wind-load of any new antenna that is to be deployed should be similar and comparable to legacy products. Such challenges require to have a higher number of radiating structures or antenna arrays to be integrated under a same radome and share the same area. Among many technical strategies, one of the key points to fulfil these requirements, is that radiating structures designed for two or more frequency bands, for example, low-band (LB) and high-band (HB), when operated in an antenna device (or an array) should be electrically invisible or mutually transparent to each other. However, conventional antenna devices have a technical problem of electrical visibility, in which when a radiating element of one frequency band is placed in the vicinity of other radiating element of a different frequency band, the performance of at least one radiating element is adversely affected. For example, when a lower frequency antenna array is overlaid on a higher frequency antenna array, the radiation generated by the higher frequency antenna array tends to get distorted. Moreover, electromagnetic fields get reflected or reradiated in an unwanted way by the lower frequency antenna array, which reduces higher frequency antenna array's directivity, increases the side lobe value, decreases the front to back ratio, worsens cross-polar discrimination values, etc., which is not desirable.

US 2019/319352 A1 discloses an antenna element. The antenna element comprises: a support structure; a radiating structure arranged on or within the support structure, said radiating structure comprising: a radiating element having a resonant frequency inside an operating frequency band of the antenna element; and a filter connected to the radiating element and configured to filter out harmonics of the operating frequency band. An antenna system is also provided, which comprises a first antenna element according to the first aspect configured to radiate in a first operating frequency band, and a second antenna element configured to radiate in a second operating frequency band, wherein the second operating frequency band overlaps with harmonics of the first operating frequency band.

WO 2022/022804 A1 discloses an antenna structure comprising a first antenna configured to emit electromagnetic radiation having a first operational frequency band and a second antenna configured to emit electromagnetic radiation having a second operational frequency band. The second antenna comprises an inductive element configured to inhibit interference of the second antenna with the electromagnetic radiation emitted from the first antenna.

Therefore, in light of the foregoing discussion, there exists a need to overcome the aforementioned drawbacks associated with the conventional antenna devices, such as dual-band or multi-band antenna devices.

SUMMARY

The present disclosure seeks to provide an antenna device with a radiating loop. The present disclosure seeks to provide a solution to the existing problem of how to achieve mutual electrical invisibility or transparency for radiating structures operating in different frequency bands in a conventional antenna device without degrading performance. An aim of the present disclosure is to provide a solution that overcomes at least partially the problems encountered in prior art and provide an improved antenna device with improved electrical invisibility or mutual transparency between two radiating structures operating in at least two different frequency bands as compared to a conventional antenna device.

The object of the present disclosure is achieved by the solutions provided in the enclosed independent claims. Advantageous implementations of the present disclosure are further defined in the dependent claims.

In one aspect, the present disclosure provides an antenna device. The antenna device comprises a first radiating structure configured to operate at a first frequency band. A second radiating structure configured to operate at a second frequency band, the second radiating structure comprising a radiating loop formed along a closed line, wherein the radiating loop is made as a coil extending along the closed line and being electrically invisible at the first frequency band.

The antenna device of the present disclosure manifests improved mutual invisibility (or transparency) in which the second radiating structure that operates at the second frequency band do not affect the performance of the first radiating structure that operate at the first frequency band even when both radiating structures are placed in the vicinity of each other. The improved electrical invisibility between two radiating structures is achieved due to the radiating loop. The radiating loop is made as a coil such that an inductance is introduced that is distributed all along the radiating loop. Such inductance changes the impedance of the radiating loop, thereby reducing the amount of scattered field (e.g. the scattered field is lower than -50dB). In other words, the radiating loop maintains its properties at the desired frequencies (i.e. at the second, lower frequency band) while being transparent (i.e. not reflecting radiation or energy) for the other frequency band (e.g. the first, higher frequency band).

The radiating loop is arranged on a circumference of the second radiating structure.

As the radiating loop is arranged on a circumference of the second radiating structure, thus the radiating loop occupies a larger area on the second radiating structure, which improves the inductance distributed all along the radiating loop at the circumference, and provides the effect of improved bandwidth of the second radiating structure.

In a further implementation form, the radiating loop has an essentially square shape in a top view.

The shape of the radiating loop dictates the amount of inductance introduced whose response varies with frequency, and thereby contributes in reducing the amount of the scattered field to improve the electrical invisibility between the radiating structures. Typically, when current is passed through a conventional coil, magnetic fields may be generated by separate turns of wire, which pass through the centre of the coil and add (i.e. superpose) to produce a strong field. However, in the antenna device of the present disclosure, any potential magnetic field is nullified by superposition as the coil is shaped as a square.

In a further implementation form, the second frequency band is lower than the first frequency band.

Typically, the use of different frequency bands can directly affect the size of radiating structures, the placement of the radiating structures, and thus the overall size and complexity of a conventional antenna device. Beneficially, the antenna device of the present disclosure manifests improved mutual invisibility in which the second radiating structure that operates at a lower frequency band do not affect the performance of the first radiating structure that operate at a comparatively higher frequency band even when both radiating structures are placed in the vicinity of each other.

In a further implementation form, the second radiating structure overlaps with the first radiating structure in a top view.

As the first radiating structure overlaps with the second radiating structure, a very compact architecture of the antenna device is achieved.

In a further implementation form, the coil comprises conductive tracks printed on different layers of a printed circuit board and connected with each other by vias.

By virtue of the use of conductive tracks printed on different layers of the printed circuit board (PCB), it becomes easy to etch and define the width, pitch and length of the coil that defines the radiating loop.

In a further implementation form, the coil comprises metal strips printed over a plastic bearing element.

By virtue of the use of the metal strips printed over a plastic bearing element, the manufacturing complexity, cost of maintenance, and an overall cost of the antenna device is reduced.

In a further implementation form, the first radiating structure is configured to be arranged on a lower plane of a support structure in a first distance to a reflector, and the second radiating structure is configured to be arranged on an upper plane of the support structure in a second distance from the lower plane.

The arrangement of the first and the second radiating structures at a first and the second distance from the lower planes enables the antenna device to radiate electromagnetic signals in multi-band with reduced interference, where the use of the radiation loop makes the interference almost negligible.

It has to be noted that all devices, elements, circuitry, units and means described in the present application could be implemented in the software or hardware elements or any kind of combination thereof. All steps which are performed by the various entities described in the present application as well as the functionalities described to be performed by the various entities are intended to mean that the respective entity is adapted to or configured to perform the respective steps and functionalities. Even if, in the following description of specific embodiments, a specific functionality or step to be performed by external entities is not reflected in the description of a specific detailed element of that entity which performs that specific step or functionality, it should be clear for a skilled person that these methods and functionalities can be implemented in respective software or hardware elements, or any kind of combination thereof. It will be appreciated that features of the present disclosure are susceptible to being combined in various combinations without departing from the scope of the present disclosure as defined by the appended claims.

Additional aspects, advantages, features and objects of the present disclosure would be made apparent from the drawings and the detailed description of the illustrative implementations construed in conjunction with the appended claims that follow.

BRIEF DESCRIPTION OF THE DRAWINGS

The summary above, as well as the following detailed description of illustrative embodiments, is better understood when read in conjunction with the appended drawings. For the purpose of illustrating the present disclosure, exemplary constructions of the disclosure are shown in the drawings. However, the present disclosure is not limited to specific methods and instrumentalities disclosed herein. Moreover, those in the art will understand that the drawings are not to scale. Wherever possible, like elements have been indicated by identical numbers.

Embodiments of the present disclosure will now be described, by way of example only, with reference to the following diagrams wherein:

FIG. 1A is a side view of an exemplary arrangement of a first radiating structure with respect to a second radiating structure in an antenna device, in accordance with an embodiment of the present disclosure;
FIG. 1B is a top view of an exemplary arrangement of a first radiating structure with respect to a second radiating structure in an antenna device, in accordance with an embodiment of the present disclosure;
FIG. 1C is an illustration of a portion of an antenna device, in accordance with an embodiment of the present disclosure;
FIG. 1D is an illustration of a square-shaped radiating loop of the antenna device of FIG. 1C, in accordance with an embodiment of the present disclosure;
FIG. 1E is an illustration of a portion of an antenna device with a close-up view of a radiating loop, in accordance with another embodiment of the present disclosure;
FIG. 1F is an illustration of a radiating loop made as a coil with conductive tracks and vias, in accordance with another embodiment of the present disclosure;
FIG. 2A is an illustration of a radiating loop with metal strips printed over a plastic bearing element, in accordance with an embodiment of the present disclosure;
FIG. 2B is a top view of the radiating loop of FIG. 2A, in accordance with another embodiment of the present disclosure;
FIG. 2C is a bottom view of the radiating loop of FIG. 2A, in accordance with another embodiment of the present disclosure;
FIG. 2D is a side view of the radiating loop of FIG. 2A, in accordance with another embodiment of the present disclosure;
FIG. 3 is a graphical representation that illustrates scattering analysis of an antenna device, in accordance with an embodiment of the present disclosure;
FIG. 4 is a graphical representation that depicts a radiation pattern of an antenna device, in accordance with an embodiment of the present disclosure; and
FIG. 5 is a graphical representation that depicts variation of scattered field values versus operating frequency of an antenna device, in accordance with an embodiment of the present disclosure.

In the accompanying drawings, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

## DETAILED DESCRIPTION OF EMBODIMENTS

The following detailed description illustrates embodiments of the present disclosure and ways in which they can be implemented. Although some modes of carrying out the present disclosure have been disclosed, those skilled in the art would recognize that other embodiments for carrying out or practicing the present disclosure are also possible.

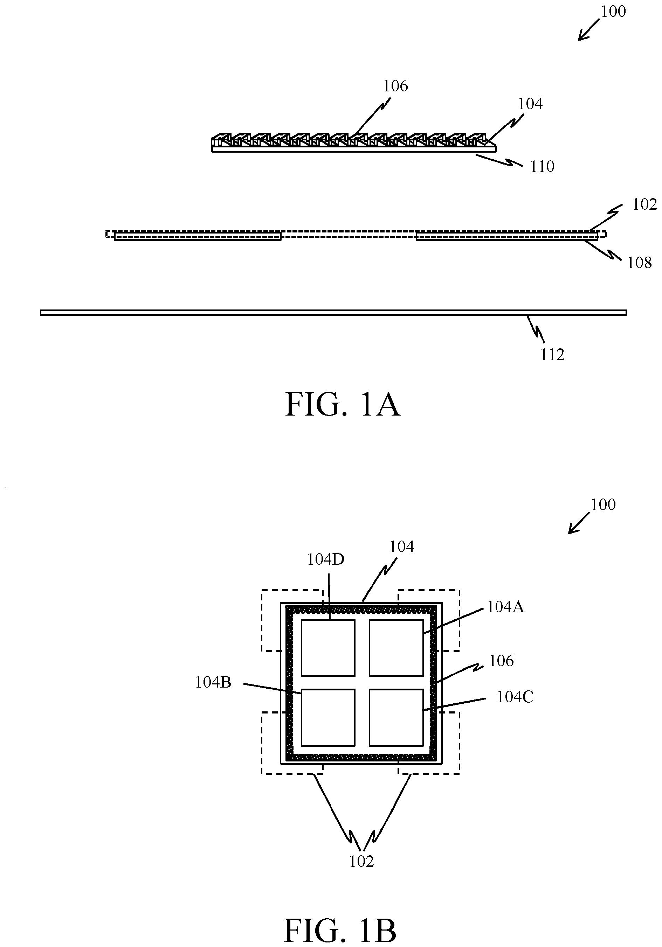

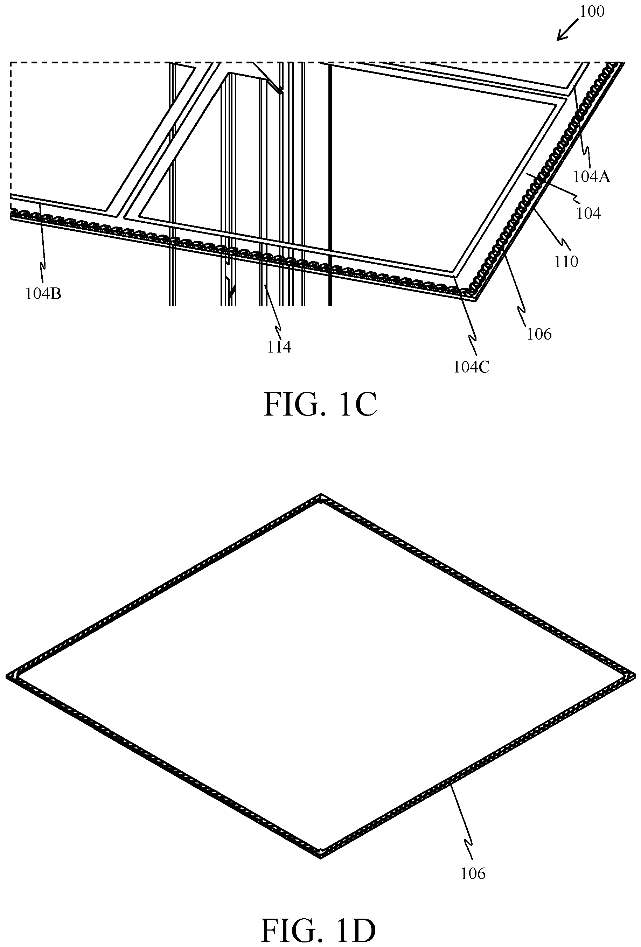

FIG. 1A is a side view of an exemplary arrangement of a first radiating structure **102** and a second radiating structure **104** in an antenna device **100**. With reference to FIG. 1A, there is shown a side view of the first radiating structure **102** on a first substrate **108** and the second radiating structure **104** with a radiating loop **106** on a second substrate **110**. In the shown example, a reflector **112** is arranged beneath the two radiating structures **102, 104**. FIG. 1A is used to depict an exemplary mutual arrangement of the second radiating structure **104** over the first radiating structure **102.** The second radiating structure **104** that includes the radiating loop **106** is shown and described in detail, for example, in FIG. 1C to 1F.

The antenna device **100** is configured to radiate electromagnetic signals in two frequency bands concurrently. In an example, the antenna device **100** may be referred to as a dual-band antenna device or a multi-band antenna device. The antenna device **100** can be used in wireless communication systems. Examples of such wireless communication systems include, but are not limited to a base station (such as an Evolved Node B (eNB), or a Next Generation NodeB (gNB)), a repeater device, or other customized telecommunication hardware.

The first radiating structure **102** refers to a radiating element or a radiator of the antenna device **100**. The first radiating structure **102** that is configured to operate at a first frequency band. In an implementation, the first radiating structure **102** includes a plurality of radiating elements that operate at the first frequency band. The first radiating structure **102** is printed on the first substrate **108.**

The second radiating structure **104** includes a plurality of radiating elements and the radiating loop **106**. The second radiating structure **104** is configured to operate at a second frequency band that is different from the first frequency band. For example, the second frequency band may be lower than the first frequency band. The second radiating structure **104** is printed on the second substrate **110.**

The radiating loop **106** is an electrically conductive element comprised in the second radiating structure **104** of the antenna device **100.** The radiating loop **106** increases the bandwidth of the second radiating structure **104,** reduces its beam width, and improves isolation of the second radiating structure **104** with adjacent radiating element, such as the first radiating structure **102,** and at the same time the radiating loop **106** is electrically invisible for the first frequency band radiated by the first radiating structure **102.**

The first substrate **108** acts as a base for the first radiating structure **102,** whereas the second substrate **110** acts as a base for the second radiating structure **104.** In an implementation, each of the first substrate **108** and the second substrate **110** is a printed circuit board (PCB). Each of the first substrate **108** or the second substrate **110** is a single layer or a dual layer printed circuit board. In an implementation, the second substrate **110** is a dual-layer printed circuit board, where the top and bottom layers of the PCB are used to etch and define the width, pitch, and length of a coil that defines the radiating loop **106.** In an example, the first substrate **108** and the second substrate **110** may be a FR4 substrate.

The reflector **112** is provided in the antenna device **100** in order to reflect and redirect RF energy in a desired direction. The reflector **112** is arranged in a first distance (i.e. closer) to the first radiating structure **102,** and the second radiating structure **104** is arranged in a second distance from the first radiating structure **102.**

FIG. 1B is a top view of an exemplary arrangement of the first radiating structure **102** with respect to the second radiating structure **104** in the antenna device **100,** in accordance with an embodiment of the present disclosure. With reference to FIG. 1B, there is shown the second radiating structure **104** that overlaps with the first radiating structure **102** in a top view. The second radiating structure **104** includes a plurality of radiating elements, such as a first radiating element **104A,** a second radiating element **104B,** a third radiating element **104C,** and a fourth radiating element **104D.** In this embodiment, the second radiating structure **104** includes four radiating elements, the four radiating elements form two electric dipoles. Alternatively, in some implementations, the second radiating structure **104** may include one radiating element instead of multiple elements. It is to be understood by a person of ordinary skill in the art that the number of radiating elements within the second radiating structure **104** can be increased or decreased without limiting the scope of the disclosure. There is further shown the radiating loop **106** comprised in the second radiating structure **104** that surrounds the plurality of radiating elements, such as the first radiating element **104A,** the second radiating element **104B,** the third radiating element **104C,** and the fourth radiating element **104D.**

In operation, the first radiating structure **102** is configured to operate at a first frequency band, while the second radiating structure **104** is configured to operate at a second frequency band. The second radiating structure **104** includes the radiating loop **106** formed along a closed line, wherein the radiating loop **106** is made as a coil extending along the closed line and being electrically invisible at the first frequency band. Alternatively stated, the first radiating structure **102** radiates radio frequency (RF) signals in the first frequency band that is different from the second frequency band in which the second radiating structure **104** radiates RF signals. As shown, the first radiating structure **102** and the second radiating structure **104** are arranged in vicinity of each other, and potentially communicate RF signals in their respective frequency bands concurrently. The radiating loop **106** of the second radiating structure **104** does not affect the performance of the first radiating structure **102** that operates at higher frequency band even when both radiating structures are placed in the vicinity of each other. An example of the radiating loop **106** formed as a continuous closed line is shown and further described in FIG. 1D. As the radiating loop **106** is in the form of a coil, an inductance is introduced that is distributed all along the coil, when in operation. Such inductance potentially changes the impedance of the radiating loop **106,** thereby reducing the amount of scattered field. In other words, the radiating loop **106** maintains its properties at the desired frequencies (i.e. at the second, lower frequency band) while being transparent (i.e. not reflecting radiation or energy) to the first frequency band (e.g. higher frequency band).

In accordance with an embodiment, the second radiating structure **104** overlaps with the first radiating structure **102** in a top view. The second radiating structure **104** is arranged over the first radiating structure **102** (as shown in FIG. 1B, in an example), which ensures a compact architecture to the antenna device **100.** In an implementation, the second radiating structure **104** resemble almost a planar structure that is printed on the second substrate.

Typically, in conventional dual-band antenna devices, when a lower frequency radiating element (or lower frequency array) is overlaid on a higher frequency radiating element (or higher frequency array), the radiation generated by the higher frequency radiating element (or higher frequency array) tends to get distorted by the lower frequency radiating element (or lower frequency array). Moreover, electromagnetic fields get reflected or reradiated in an unwanted way by the lower frequency radiating element (or lower frequency array) which reduces higher frequency radiating element's (or higher frequency array's) directivity, increases the side lobes, decreases the front to back, worsens the cross polar discrimination, etc. In contradiction to the conventional dual-band antenna devices, the radiating loop **106** of the second radiating structure **104** that surrounds all the radiating elements of second radiating structure **104,** avoid or at least significantly reduce any distortion of radiation generated by the first radiating structure **102.** Thus, in a way the radiating loop **106** enables mutual invisibility or transparency, where the second radiating structure **104** of one frequency band (e.g. lower frequency band) in the vicinity of the first radiating structure **102** of a different frequency band (higher frequency) does not affect the performance of each other. Alternatively, if the rest elements of the second radiating structure **104** are designed to be electrically invisible at the first frequency band, by means of any appropriate known techniques, the whole second radiating structure **104,** including the radiating loop **106,** will be electrically transparent to the first frequency band.

FIG. 1C is an illustration of a portion of an antenna device, in accordance with an embodiment of the present disclosure. FIG. 1C is described in conjunction with elements from FIGs. 1A and 1B. With reference to FIG. 1C, there is shown the second radiating structure **104** of the antenna device **100.** The second radiating structure **104** includes the radiating loop **106** and a plurality of radiating elements, such as the first radiating element **104A,** the second radiating element **104B,** and the third radiating element **104C,** enclosed in the radiating loop **106.** The second radiating structure **104** is printed on the second substrate **110,** which is arranged on a support structure **114.**

In this embodiment, the second radiating structure **104** includes four radiating elements (the fourth not visible as only a portion of the antenna device **100** is depicted in FIG. 1C), the four radiating elements form two electric dipoles. The second radiating structure **104** is configured to operate at a second frequency band that is different from the first frequency band. For example, the second frequency band may be lower than the first frequency band.

The support structure **114** provides support and mechanical strength to the first substrate (e.g. the first substrate **108** of FIG. 1A) as well as to the second substrate **110.** In an example, the support structure **114** may be made of plastic.

In accordance with an embodiment, the radiating loop **106** is arranged on a circumference of the second radiating structure **104.** The radiating loop **106** adds an inductance that is distributed all along the radiating loop **106** placed on the circumference (i.e. near edges) of the second radiating structure **104.** Moreover, the shape (including density, radius, number of turns per defined length, etc.) of the radiating loop **106** dictates the amount of inductance introduced and, the frequency response varies with the operating frequency of the first radiating structure (e.g. the first radiating structure **102** of FIG. 1A and 1B) and the second radiating structure **104.** The amount of inductance added by the radiating loop **106** changes the impedance of the radiating loop **106** accordingly and makes it electrically transparent for the first frequency band. In some implementations, the transparency is achieved whenever scattered field value is lower than -50 decibel (dB). The scattered field is potentially a measure of surface current at the first frequency bands (e.g. higher frequency band).

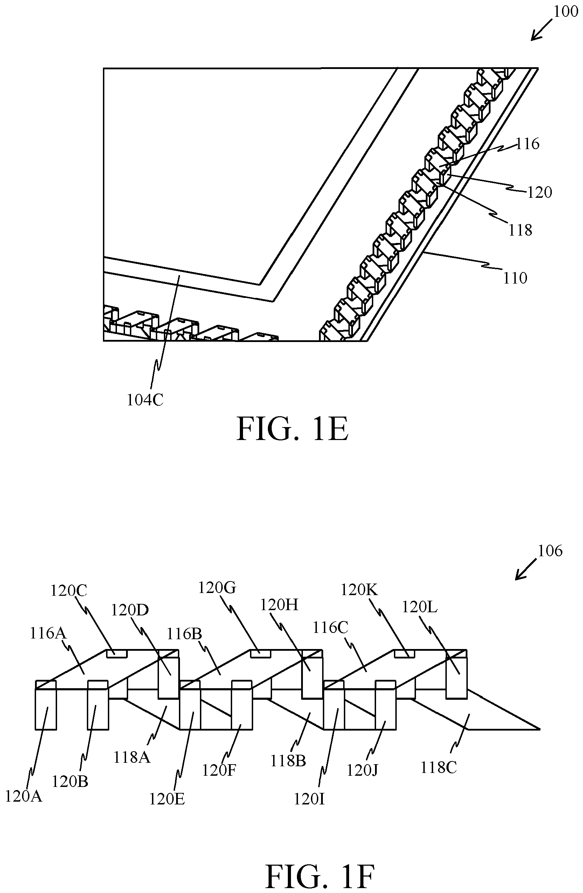

In accordance with another embodiment, the radiating loop **106** has essentially square shape in a top view. The radiating loop **106** is arranged on the second radiating structure **104** along the closed line, and the closed line describes a square shape. The radiating loop **106** in the top view represents a shape of the square, as shown in FIG. 1D, in an example. Typically, when current is passed through a conventional coil, magnetic fields may be generated by separate turns of wire, which pass through the centre of the coil and add (i.e. superpose) to produce a strong magnetic field. However, in the antenna device **100,** any potential magnetic field is nullified by superposition as the coil that defines the radiating loop **106** is shaped as a square. The shape and structure of the radiating loop **106** is further described in detail, for example, in FIGs. 1D, 1E, and 1F.

In accordance with an embodiment, the second frequency band is lower than the first frequency band. The second frequency band is the frequency band in which the second radiating structure **104** operates, whereas the first radiating structure (e.g. the first radiating structure **102** of FIG. 1A and 1B) operates in the first frequency band. Alternatively stated, the first radiating structure is configured to operate at a frequency that is higher than the second frequency band. For example, the first frequency band corresponds to a medium band (e.g. 1.427 to 2.2 GHz) or a high band (e.g. 1.71 to 2.69 GHz), and the second frequency band is lower than the first frequency band (e.g. a low band, such as 690 to 960 MHz). In another example, the first frequency band corresponds to "F1" band that is mm Wave frequency of 5G NR frequency band, whereas the second frequency band corresponds to "F2" frequency band (i.e. sub-6 GHz frequency).

In accordance with an embodiment, the first radiating structure (e.g. the first radiating structure **102** of FIG. 1A and 1B) is configured to be arranged on a lower plane of the support structure **114** in a first distance to the reflector (e.g. the reflector **112** of FIG. 1A), and the second radiating structure **104** is configured to be arranged on an upper plane of the support structure **114** in a second distance from the lower plane. The support structure **114** provides support and mechanical strength to the first substrate (e.g. the first substrate **108** of FIG. 1A) as well as to the second substrate **110.** The support structure **114** has a lower plane and the upper plane. The first substrate (e.g. the first substrate **108** of FIG. 1A) is arranged on the lower plane of the support structure **114,** and the first substrate acts as a base for the first radiating structure. The second substrate **110** is arranged on the upper plane of the support structure **114,** and the second substrate **110** acts as a base for the second radiating structure **104.** The arrangement of the first radiating structure and the second radiating structure **104** at different distances from the reflector plane enables the antenna device **100** to radiate electromagnetic signals in different frequency bands with reduced interference, where the use of the radiating loop **106** in the second radiating structure **104** further makes signal interference almost negligible. Moreover, the reflector is integrated in the antenna device **100** in order to reflect and redirect RF energy in a desired direction. The reflector (e.g. the reflector **112** of FIG. 1A) is arranged closer to the lower plane of the support structure **114** than the upper plane of the support structure **114**. In other words, the first radiating structure arranged on the lower plane of the support structure **114** is at the first distance from the reflector (i.e. comparatively closer to the reflector), whereas the second radiating structure **104** when positioned on the upper plane of the support structure **114** is at the second distance (i.e. at a greater distance) from the lower plane and comparatively not so close to the reflector. The reflector by reflecting the RF energy, increases gain in a given direction.

FIG. 1D is an illustration of a radiating loop of the antenna device of FIG. 1C, in accordance with an embodiment of the present disclosure. FIG. 1D is described in conjunction with elements from FIG. 1C. With reference to FIG. 1D, there is shown a configuration of a radiating loop such as the radiating loop **106** of the antenna device **100** of FIG. 1C.

The radiating loop **106** is made as a coil and arranged on a circumference of the second radiating structure **104**. The radiating loop **106** adds an inductance that is distributed all along the radiating loop **106** which is placed on the circumference (i.e. near edges) of the second radiating structure **104**. Generally, a value of inductance (represented by L) of the radiating loop **106** (or the coil) depends on the shape (e.g. density, radius, etc.) of the radiating loop **106** (or the coil) according to the following equation (equation 1)

$$L = \frac{\mu N^2 A}{l} \qquad (1)$$

where, A is cross sectional area of the radiating loop **106** (or coil), l is length of the radiating loop **106** (or coil) and N is number of turns of the radiating loop **106** (or coil). For a given value of inductance (i.e. L) of the radiating loop **106** (or coil), the frequency response of the radiating loop **106** varies according to an operating frequency. This is because the impedance (represented by Zl) of the radiating loop **106** depends on the operating frequency and the inductance (i.e. L) of the radiating loop **106** according to the following equation (i.e. equation 2)

$$Zl = j\omega L \qquad (2)$$

where, Zl is impedance offered by the radiating loop **106** to the first radiating structure **102** of the antenna device **100.**

For the given value of inductance (i.e. L), the impedance (i.e. Zl) depends only upon the operating frequency. Therefore, at a low frequency, the impedance (i.e. Zl) is low and the radiating loop **106** (or coil) acts as a short circuit and behaves like a typical coil. However, at a high frequency, the impedance (i.e. Zl) becomes high and the radiating loop **106** (or coil) acts as an open circuit (or transparent). Thus, by virtue of the high impedance (i.e. Zl), the coil that defines the radiating loop **106** become transparent (i.e. open circuit) to the first frequency band (i.e. higher frequency band) which is radiated by the first radiating structure **102**. Additionally, the radiating loop **106** (or coil) behaves like a series of non-connected strips.

For a given value of frequency, the impedance (i.e. Zl) depends only upon the inductance (i.e. L) which varies in direct proportionate with the number of turns (i.e. N) and the cross-sectional area of the radiating loop **106** (or coil). Higher the number of turns (or higher the density), higher is the value of inductance, and higher is the resulting impedance (i.e. Zl). Hence, at high density, the radiating loop **106** (or coil) acts like an open circuit. In this way, by controlling the density or by controlling the number of turns of the coil that defines the radiating loop **106,** the radiating loop **106** can be made transparent (i.e. open circuit) at the first frequency band. Therefore, by use of the radiating loop **106** in the second radiating structure **104,** the radiation pattern of the first radiating structure **102** (of FIG. 1A and 1B) is not affected.

The radiating loop **106** is arranged along the closed line, and the closed line describes a square shape. Typically, when current is passed through a conventional coil, magnetic fields may be generated by separate turns of wire, which pass through the centre of the coil and add (i.e. superpose) to produce a strong magnetic field. However, in the antenna device **100,** any potential magnetic field is nullified by superposition as the coil that defines the radiating loop **106** is shaped as a square.

FIG. 1E is an illustration of a portion of an antenna device with a close-up view of a radiating loop, in accordance with another embodiment of the present disclosure. FIG. 1E is described in conjunction with elements from FIGs. 1C and 1D. With reference to FIG. 1E, there is shown a portion of an antenna device (such as the antenna device **100**) with a close-up view of a radiating loop (such as the radiating loop **106**). The radiating loop **106** includes an upper conductive track **116** and a lower conductive track **118**. The upper conductive track **116** and the lower conductive track **118** are connected with each other by use of a plurality of vias **120**.

The radiating loop **106** (or the coil) comprises conductive tracks such as the upper conductive track **116** and the lower conductive track **118** which are printed on different layers of a printed circuit board (PCB). The different layers of the PCB include top and bottom layers which are used to etch and define a width, pitch and length of the radiating loop **106** (or the coil). The plurality of vias **120** is used to connect the top and bottom layers of the PCB. The plurality of vias **120** required depends on the width of the upper conductive track **116** and the lower conductive track **118**. Typically, one or two vias of the plurality of vias **120** are enough to connect the upper conductive track **116** and the lower conductive track **118**. However, it is to be understood by one of ordinary skill in the art that the number of vias in the plurality of vias **120** can be different on requirement basis without limiting the scope of the disclosure.

The upper conductive track **116** and the lower conductive track **118** have a quadratic (i.e. a polygon with four edges or sides) shape and are connected to each other through the plurality of vias **120**. The plurality of vias **120** are arranged on the edges of the upper conductive track **116** and the lower conductive track **118**. The plurality of vias **120** are configured to support the upper conductive track **116** and the lower conductive track **118**.

FIG. 1F is an illustration of a radiating loop made as a coil with conductive tracks and vias, in accordance with another embodiment of the present disclosure. FIG. 1F is described in conjunction with elements from FIGs. 1B, 1C, 1D, and 1E. With reference to FIG. 1F, there is shown the radiating loop **106** (e.g. the radiating loop **106** of FIGs. 1A to 1D) made as a coil with conductive tracks and vias.

In an implementation, the upper conductive track **116** of the radiating loop **106** includes a plurality of upper conductive tracks such as a first upper conductive track **116A,** a second upper conductive track **116B,** and a third upper conductive track **116C.** Similarly, the lower conductive track **118** of the radiating loop **106** includes a plurality of lower conductive tracks such as a first lower conductive track **118A,** a second lower conductive track **118B,** and a third lower conductive track **118C.** The upper conductive track **116** and the lower conductive track **118** are arranged diagonally but in the opposite direction as compared to each other. For example, the first upper conductive track **116A** is connected with a preceding lower conductive track (not shown here) and with the first lower conductive track **118A** using the plurality of vias **120** such as a first via **120A,** a second via **120B,** a third via **120C** and a fourth via **120D.** The second upper conductive track **116B** is connected to the first lower conductive track **118A** and with the second lower conductive track **118B** by use of the plurality of vias **120** such as a fifth via **120E,** a sixth via **120F,** a seventh via **120G,** and an eighth via **120H.** Similarly, the third upper conductive track **116C** is connected to the second lower conductive track **118B** and with the third lower conductive track **118C** by use of the plurality of vias **120** such as a nineth via **1201,** a tenth via **120J,** an eleventh via **120K,** and a twelfth via **120L.**

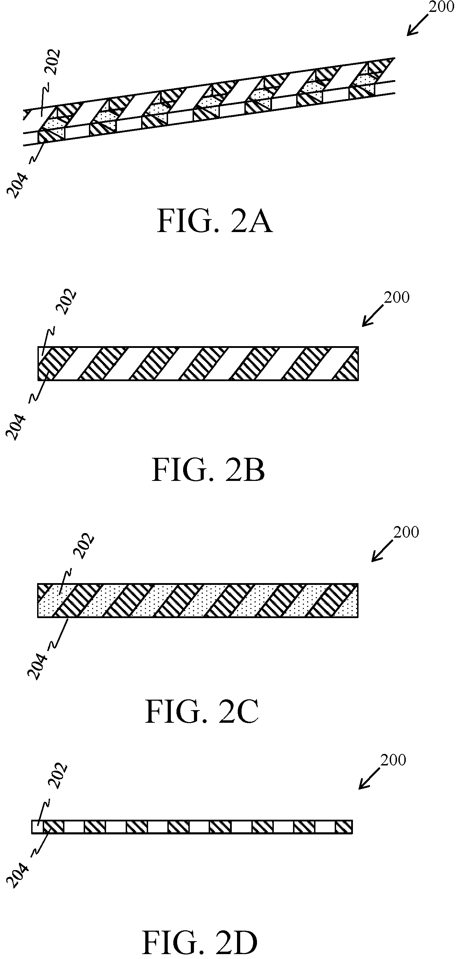

FIG. 2A is an illustration of a radiating loop with metal strips printed over a plastic bearing element, in accordance with an embodiment of the present disclosure. FIG. 2A is described in conjunction with elements from FIGs. 1A to 1F. With reference to FIG. 2A, there is shown a radiating loop **200.** The radiating loop **200** includes a plurality of metal strips **202** which is printed over a plastic bearing element **204.**

The radiating loop **200** corresponds to the radiating loop **106** of FIG. 1C. In an implementation, polyethylene plastic (PEP) or a similar technology is used to print (i.e. etch or deposit) the plurality of metal strips **202** over the plastic bearing element **204** in order to generate the radiating loop **200.** The plurality of metal strips **202** and the plastic bearing element **204** are of the same dimensions throughout the circumference of the second radiating structure **104.** The plurality of metal strips **202** are arranged around the plastic bearing element **204** in a continuous manner. However, it is to be understood by one of ordinary skill in the art that another similar technology can be used to print the plurality of metal strips **202** over the plastic bearing element **204** without limiting the scope of the disclosure.

FIG. 2B is a top view of the radiating loop of FIG. 2A, in accordance with another embodiment of the present disclosure. FIG. 2B is described in conjunction with elements from FIG. 2A. With reference to FIG. 2B, there is shown a top view of the radiating loop **200** of FIG. 2A. In the top view, the plurality of metal strips **202** of the radiating loop **200** appears to have a quadratic shape and diagonally arranged over the top surface of the plastic bearing element **204.**

FIG. 2C is a bottom view of the radiating loop of FIG. 2A, in accordance with another embodiment of the present disclosure. FIG. 2C is described in conjunction with elements from FIG. 2A. With reference to FIG. 2C, there is shown a bottom view of the radiating loop **200** of FIG. 2A. In the bottom view, the plurality of metal strips **202** of the radiating loop **200** appears to have a quadratic shape and arranged on bottom surface of the plastic bearing element **204.**

FIG. 2D is a side view of the radiating loop of FIG. 2A, in accordance with another embodiment of the present disclosure. FIG. 2D is described in conjunction with elements from FIG. 2A. With reference to FIG. 2D, there is shown a side view of the radiating loop **200** of FIG. 2A. In the side view, the plurality of metal strips **202** of the radiating loop **200** appears to have a rectangular shape and arranged on side surface of the plastic bearing element **204.**

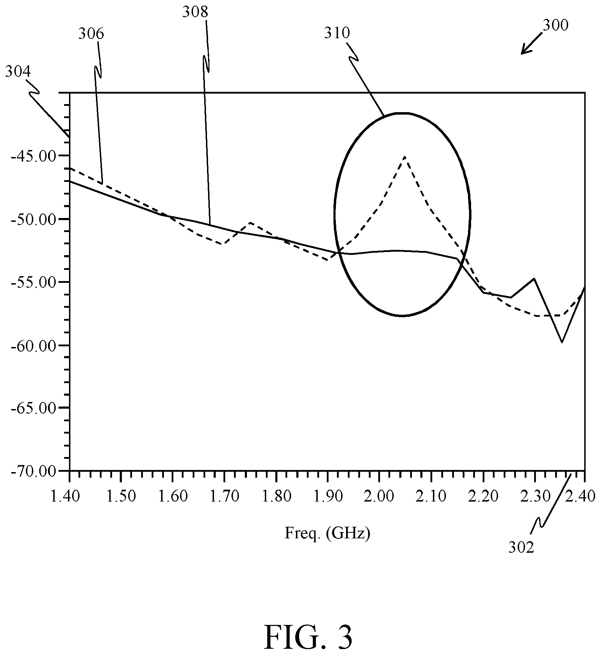

FIG. 3 is a graphical representation that illustrates scattering analysis of an antenna device, in accordance with an embodiment of the present disclosure. FIG. 3 is described in conjunction with elements from FIGs. 1A to 1F, and 2A to 2D. With reference to FIG. 3, there is shown a graphical representation **300** of an antenna device such as the antenna device **100** of FIG. 1C. The graphical representation **300** includes a X-axis **302** that denotes frequency in Gigahertz (GHz) and a Y-axis **304** that represents scattered power in decibel (dB).

The scattering analysis of the antenna device **100** is performed by use of a high frequency structure simulator (HFSS) tool. In the graphical representation, a first line **306** represents scattering behaviour of a conventional antenna device. A second line **308** represents scattering behaviour of the antenna device **100.** The graphical representation **300** further includes an elliptical region **310** which highlights a difference between the scattering behaviour of the conventional antenna device and the antenna device **100** at a high frequency range (approximately 1.90GHz - 2.20GHz). In the elliptical region **310,** the antenna device **100** has lower value of the scattered field (i.e. less than -50dB) in comparison to the conventional antenna device. The reason is that in the conventional antenna device, a typical ring is used that is not transparent at the high frequency range and degenerates the radiation pattern of any radiating structure (or antenna array) which is placed below the typical ring. However, in the antenna device **100,** the ring in the form of the radiating loop **106** (of FIG. 1C) becomes transparent to the first radiating structure **102** which is placed below the radiating loop **106** and hence, the radiating loop **106** does not affect the radiation pattern of the first radiating structure **102.** Thus, the antenna device **100** manifests lower value of the scattered field (i.e. less than -50dB) because of the radiating loop **106.**

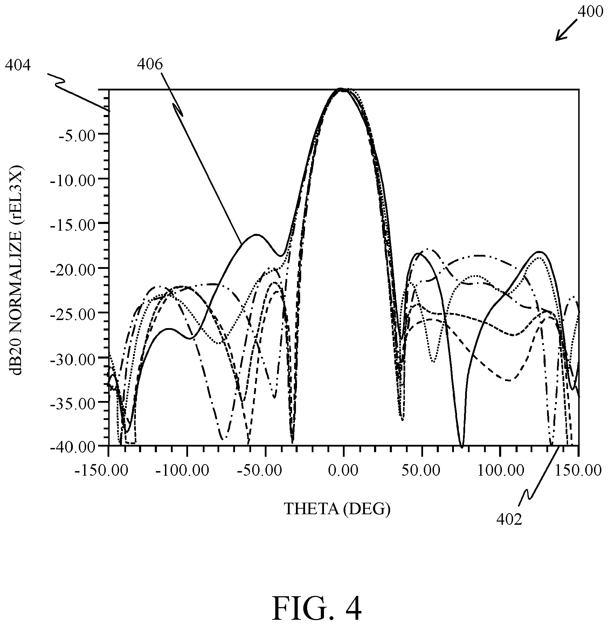

FIG. 4 is a graphical representation that depicts a radiation pattern of an antenna device, in accordance with an embodiment of the present disclosure. FIG. 4 is described in conjunction with elements from FIGs. 1C to 1F, 2A to 2D, and 3. With reference to FIG. 4, there is shown a graphical representation **400** that represents a radiation pattern of an antenna device such as the antenna device **100** of FIG. 1C. The graphical representation **400** includes a X-axis **402** that represents Theta values in degree (deg) and a Y-axis **404** that represents normalized values of the radiation field in decibel (dB).

In the graphical representation **400,** a plurality of lines **406** represents various radiation patterns of the antenna device **100.** The radiation patterns represented by the plurality of lines **406** are obtained when the radiating loop **106** of the second radiating structure **104** (or the low frequency array) is transparent (i.e. open circuit) to the first radiating structure **102** (or the high frequency array) at high frequencies. Hence, the radiating loop **106** does not affect the radiation pattern of the first radiating structure **102.** Therefore, the antenna device **100** exhibits lower values of the scattered field in comparison to a conventional antenna device which exhibits relatively higher values of the scattered field. In the conventional antenna device, a conventional antenna array operating at a lower frequency and including a typical ring (or ring along with probes) is not transparent to another antenna array operating at a higher frequency, and thus, deteriorates the radiation pattern of the antenna array operating at the higher frequency. Therefore, the conventional antenna device exhibits higher values of the scattered field which is not preferable.

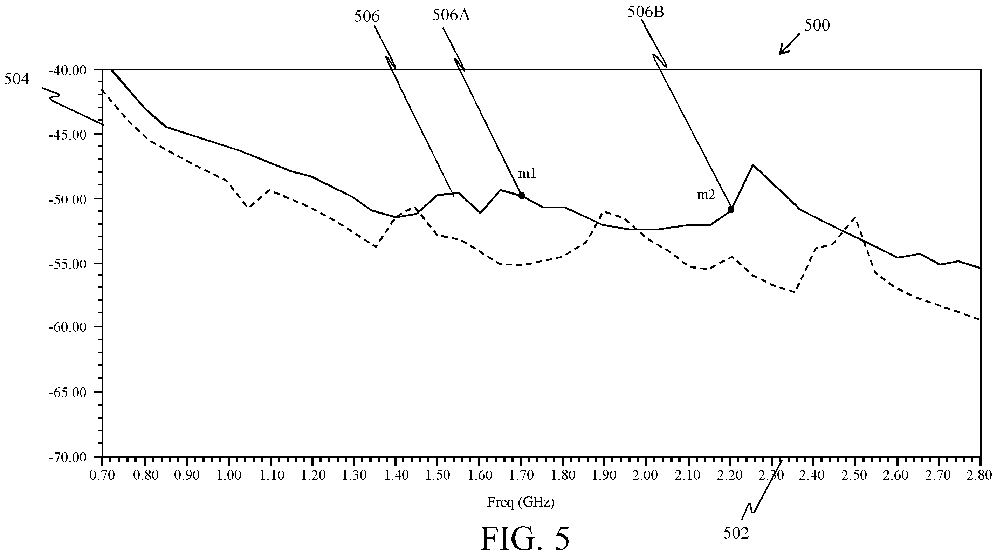

FIG. 5 is a graphical representation that depicts variation of scattered field values versus operating frequency of an antenna device, in accordance with an embodiment of the present disclosure. FIG. 5 is described in conjunction with elements from FIGs. 1C to 1F. With reference to FIG. 5, there is shown a graphical representation **500** that represents variation of scattered field values versus operating frequency of an antenna device such as the antenna device **100** of FIG. 1C. The graphical representation **500** includes a X-axis **502** that represents frequency in GHz and a Y-axis **504** that represents scattered field values in decibels (dB).

In the graphical representation **500,** a first line **506** represents variation of the scattered field values with respect to an operating frequency of the antenna device **100.** The first line **506** depicts value of the scattered field decreases with increase in operating frequency of the antenna device **100.** The first line **506** includes a first point **506A** (also represented as m1) and a second point **506B** (also represented as m2). The first point **506A** (i.e. m1) has a value of scattered field -49.70 dB at a frequency of 1.7GHz. The second point **506B** (i.e. m2) has a value of scattered field - 50.91 dB at a frequency of 2.2GHz. The second point **506B** (i.e. m2) has a relatively lower value of the scattered value because of the high operating frequency. The reason is that by increasing the density of the radiating loop **106,** inductance (i.e. L) of the radiating loop **106** increases which further results into an increase in the impedance (i.e. Zl) of the radiating loop **106** according to the equation 2. In addition to the increase in the inductance (i.e. L), there is also an increase in the operating frequency at each step and hence, there is a further increase in the impedance (i.e. Zl). The further increase in the impedance (i.e. Zl) results into a more reduced value of the scattered field. The density of the radiating loop **106** (or the coil) is increased by increasing the number of turns (i.e. N) of the coil.

Modifications to embodiments of the present disclosure described in the foregoing are possible without departing from the scope of the present disclosure as defined by the accompanying claims. Expressions such as "including", "comprising", "incorporating", "have", "is" used to describe and claim the present disclosure are intended to be construed in a non-exclusive manner, namely allowing for items, components or elements not explicitly described also to be present. Reference to the singular is also to be construed to relate to the plural. The word "exemplary" is used herein to mean "serving as an example, instance or illustration". Any embodiment described as "exemplary" is not necessarily to be construed as preferred or advantageous over other embodiments or to exclude the incorporation of features from other embodiments. The word "optionally" is used herein to mean "is provided in some embodiments and not provided in other embodiments". It is appreciated that certain features of the present disclosure, which are, for clarity, described in the context of separate embodiments, may also be provided in combination in a single embodiment.

## Claims

1.  An antenna device (100), comprising:

    - a first radiating structure (102) configured to operate at a first frequency band, and
    - a second radiating structure (104) configured to operate at a second frequency band, the second radiating structure (104) comprising a radiating loop (106, 200) formed along a closed line,

wherein the radiating loop (106, 200) is arranged on a circumference of the second radiating structure (104), **characterized in that**

the radiating loop (106, 200) is made as a coil extending along the closed line and configured to be electrically invisible at the first frequency band. \

2. The antenna device (100) of claim 1, wherein the radiating loop (106, 200) has an essentially square shape in a top view.

3. The antenna device (100) of any of claim 1 to 2, wherein the second frequency band is lower than the first frequency band.

4. The antenna device (100) of any of claim 1 to 3, wherein the second radiating structure (104) overlaps with the first radiating structure (102) in a top view.

5. The antenna device (100) of any of claims 1 to 4, wherein the coil (106, 200) comprises conductive tracks printed on different layers of a printed circuit board and connected with each other by vias.

6. The antenna device (100) of any of claims 1 to 4, wherein the coil (106, 200) comprises metal strips (202) printed over a plastic bearing element (204).

7. The antenna device (100) of any of claims 1 to 6, wherein the first radiating structure (102) is configured to be arranged on a lower plane of a support structure (114) in a first distance to a reflector (112), and the second radiating structure (104) is configured to be arranged on an upper plane of the support structure (114) in a second distance from the lower plane.

8. A base station, comprising the antenna device of any of claims 1 to 7.

**Patentansprüche**

1. Antennenvorrichtung (100), umfassend:

- eine erste Strahlungsstruktur (102), die dazu konfiguriert ist, in einem ersten Frequenzband zu arbeiten, und
- eine zweite Strahlungsstruktur (104), die dazu konfiguriert ist, in einem zweiten Frequenzband zu arbeiten, wobei die zweite Strahlungsstruktur (104) eine Strahlungsschleife (106, 200) umfasst, die entlang einer geschlossenen Linie gebildet ist,

wobei die Strahlungsschleife (106, 200) auf einem Umfang der zweiten Strahlungsstruktur (104) angeordnet ist, **dadurch gekennzeichnet, dass**

die Strahlungsschleife (106, 200) als eine Spule hergestellt ist, die sich entlang der geschlossenen Linie erstreckt und dazu konfiguriert ist, bei dem ersten Frequenzband elektrisch unsichtbar zu sein.

2. Antennenvorrichtung (100) gemäß Anspruch 1, wobei die Strahlungsschleife (106, 200) in einer Draufsicht eine im Wesentlichen quadratische Form aufweist.

3. Antennenvorrichtung (100) gemäß einem der Ansprüche 1 bis 2, wobei das zweite Frequenzband niedriger als das erste Frequenzband ist.

4. Antennenvorrichtung (100) gemäß einem der Ansprüche 1 bis 3, wobei die zweite Strahlungsstruktur (104) in einer Draufsicht mit der ersten Strahlungsstruktur (102) überlappt.

5. Antennenvorrichtung (100) gemäß einem der Ansprüche 1 bis 4, wobei die Spule (106, 200) leitfähige Bahnen umfasst, die auf unterschiedliche Schichten einer Leiterplatte gedruckt und durch Durchkontaktierungen miteinander verbunden sind.

6. Antennenvorrichtung (100) gemäß einem der Ansprüche 1 bis 4, wobei die Spule (106, 200) Metallstreifen (202) umfasst, die über ein Kunststofflagerelement (204) gedruckt sind.

7. Antennenvorrichtung (100) gemäß einem der Ansprüche 1 bis 6, wobei die erste Strahlungsstruktur (102) dazu konfiguriert ist, auf einer unteren Ebene einer Trägerstruktur (114) in einem ersten Abstand zu einem Reflektor (112) angeordnet zu werden, und die zweite Strahlungsstruktur (104) dazu konfiguriert ist, auf einer oberen Ebene der Trägerstruktur (114) in einem zweiten Abstand von der unteren Ebene angeordnet zu werden.

8. Basisstation, umfassend die Antennenvorrichtung gemäß einem der Ansprüche 1 bis 7.

**Revendications**

1. Dispositif d'antenne (100), comprenant :

- une première structure rayonnante (102) configurée pour fonctionner à une première bande de fréquence, et

- une seconde structure rayonnante (104) configurée pour fonctionner à une seconde bande de fréquence, la seconde structure rayonnante (104) comprenant une boucle rayonnante (106, 200) formée le long d'une ligne fermée, dans lequel la boucle rayonnante (106, 200) est disposée sur une circonférence de la seconde structure rayonnante (104), **caractérisé en ce que**

la boucle rayonnante (106, 200) est réalisée sous la forme d'une bobine se prolongeant le long de la ligne fermée et configurée pour être électriquement invisible à la première bande de fréquence.

2. Dispositif d'antenne (100) selon la revendication 1, dans lequel la boucle rayonnante (106, 200) présente une forme essentiellement carrée dans une vue de dessus.

3. Dispositif d'antenne (100) selon l'une quelconque des revendications 1 à 2, dans lequel la seconde bande de fréquence est inférieure à la première bande de fréquence.

4. Dispositif d'antenne (100) selon l'une quelconque des revendications 1 à 3, dans lequel la seconde structure rayonnante (104) chevauche la première structure rayonnante (102) dans une vue de dessus.

5. Dispositif d'antenne (100) selon l'une quelconque des revendications 1 à 4, dans lequel la bobine (106, 200) comprend des pistes conductrices imprimées sur différentes couches d'une carte de circuit imprimé et connectées les unes aux autres par des trous de liaison.

6. Dispositif d'antenne (100) selon l'une quelconque des revendications 1 à 4, dans lequel la bobine (106, 200) comprend des bandes métalliques (202) imprimées sur un élément de support en plastique (204).

7. Dispositif d'antenne (100) selon l'une quelconque des revendications 1 à 6, dans lequel la première structure rayonnante (102) est configurée pour être disposée sur un plan inférieur d'une structure de support (114) à une première distance d'un réflecteur (112), et la seconde structure rayonnante (104) est configurée pour être disposée sur un plan supérieur de la structure de support (114) à une seconde distance du plan inférieur.

8. Station de base, comprenant le dispositif d'antenne selon l'une quelconque des revendications 1 à 7.

100

106

104

110

102

108

112

# FIG. 1A

100

104D

104

104A

104B

106

104C

102

# FIG. 1B

FIG. 1C

FIG. 1D

FIG. 1E

FIG. 1F

200

202

204

FIG. 2A

202

200

204

FIG. 2B

202

200

204

FIG. 2C

202

200

204

FIG. 2D

FIG. 3

FIG. 4

FIG. 5

**EP 4 211 749 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2019319352 A1
- WO 2022022804 A1